# EUROPEAN PATENT SPECIFICATION

(11) **EP 4 684 159 B1**
(45) Date of publication and mention of the grant of the patent: **23.09.2026**
(21) Application number: 24709778.5
(22) Date of filing: 12.03.2024
(51) Int. Cl.: F21K 9/232, F21V 23/04, F21Y 115/10

(54) **LED FILAMENT AND LED FILAMENT LAMP**
LED-FILAMENT UND LED-FILAMENTLAMPE
FILAMENT À DEL ET LAMPE À FILAMENT À DEL

(30) Priority: 20.03.2023 EP 23162769
(43) Date of publication of application: 28.01.2026
(73) Proprietor: Signify Holding B.V., 5656 AE Eindhoven (NL)
(72) Inventor: VAN BOMMEL, Ties, 5656 AE Eindhoven (NL); HIKMET, Rifat, Ata, Mustafa, 5656 AE Eindhoven (NL)
(74) Representative: Verweij, Petronella Daniëlle
(86) International application number: PCT/EP2024/056518
(87) International publication number: WO 2024/194082

(56) References cited:
- CN-A- 107 202 256
- CN-A- 109 638 005
- US-A1- 2020 303 356

## Description

### FIELD OF THE INVENTION

The present invention relates to a LED filament, comprising an elongated carrier and a plurality of LEDs mounted on the carrier, and a LED filament lamps, i.e. a lamp comprising an envelope containing a LED filament and a connector for mechanical and electrical connection of the lamp.

### BACKGROUND OF THE INVENTION

In recent years, LEDs (light emitting diodes) have become the dominating type of light sources in many applications, thanks to their impressive energy efficiency. One example is LED lamps, which to a large extent have replaced incandescent lamps having a heated wire filament in an air-tight envelope.

One drawback of LED lamps is that the emitted light may be perceived as different than that emitted by incandescent lamps. Various efforts have therefore been made to make LED lamps resemble incandescent lamps. One specific result of these efforts is the LED filament, i.e. a plurality of LEDs arranged on an elongated carrier, and covered by a luminescent encapsulant. The light emitted from a LED filament resembles, to a large extent, that emitted by the wire filament in an incandescent lamp.

A light bulb with LED filaments (referred to as a LED filament lamp) is designed to resemble a traditional incandescent light bulb with one or several visible LED filaments for aesthetic and light distribution purposes. LED filament lamps have become increasingly popular, and are commercially available as lamps for domestic as well as commercial use.

Some LED filament lamps are controllable with respect to color point and color temperature, and for this purpose there are LED filaments having two individually controllable strings of blue LEDs, where the LEDs in one of the strings are covered by small spots of highly luminescent encapsulant. All LEDs are then covered by a general encapsulant, slightly less luminescent than the spots. As a result, the two LED strings will be exposed to different amounts of luminescence, and thus provide white light of different color temperature (correlated color temperature, CCT). By controlling the two strings, the overall color temperature of the LED filament can be controlled.

A drawback with such controllable LED filaments is that the CCT range is rather restricted, typically 2200-2700 K, and high temperature light cannot be provided.

US 2020/303356 discloses a LED filament.

### GENERAL DISCLOSURE OF THE INVENTION

It is an object of the invention to provide a LED filament with improved CCT controllability.

This and other objects are achieved by a LED filament providing LED filament light comprising an elongated carrier with a plurality of blue LEDs mounted on a mounting side of the elongated carrier, wherein the plurality of blue LEDs includes a first individually controllable array of blue LEDs emitting first blue LED light, a second individually controllable array of blue LEDs emitting second blue LED light, and a third individually controllable array of blue LEDs emitting third blue LED light. The LED filament further includes an elongated encapsulant layer covering all LEDs in the first individually controllable array and all LEDs in the second individually controllable array, the elongated encapsulant layer formed by a first luminescent material having a first concentration, C1, of luminescent particles.

The blue LEDs in the second individually controllable array are covered by first encapsulant spots formed by a second luminescent material having a second concentration, C2, of luminescent particles, wherein C2>C1, and the blue LEDs in the third individually controllable array are covered by second encapsulant spots, wherein (i) the second encapsulant spots are free from a luminescent material, or (ii) the second encapsulant spots are formed by a third luminescent material having a third concentration, C3, of luminescent particles, and wherein C3<C1. The second encapsulant spots are at least partly covered by the elongated encapsulant layer.

A "blue" LED is here intended to mean a LED which is configured to emit light in the blue region of the visible light spectrum.

By covering the LEDs in the third array with encapsulant spots having less luminescence than the third luminescent material, light emitted from LEDs in the third array will be subject to less luminescence. As a consequence, the blue light will be wavelength converted to a smaller degree, resulting in a higher color temperature. The second encapsulant spots may be completely non-luminescent, but may also be luminescent to some extent, but less than the first luminescent material.

In that case, the concentration of luminescent particles C3 in the third luminescent material is preferable less than 0.8 of the concentration C1 of luminescent particles in the first luminescent material, i.e. C3/C1<0.8. More preferably, C3/C1<0.5, and most preferably C3/C1<0.3

The concentration C1 of luminescent particles in the first luminescent material is preferable less than 0.8 of the concentration C2 of luminescent particles in the second luminescent material, i.e. C1/C2<0.8. More preferably C1/C2<0.5, and most preferably C1/C2<0.3.

The second encapsulant spots may be transparent, such that they do not scatter the light emitted by the blue LEDs in the third array. Alternatively, the second encapsulant spots may be translucent, such that they diffuse the light emitted by the blue LEDs in the third array.

It is noted that the light eventually emitted from the LED filament, referred to as LED filament light, will be a mix of contributions from one or more of the first blue LED light, the first converted light, the second blue LED light, the second converted light, the third blue LED light, and the third converted light.

The thickness of the second encapsulant spots may be greater than the thickness of the first encapsulant spots, so that the blue light from LEDs in the third array is wavelength converted even less.

In some embodiments, the elongated encapsulant layer covers all LEDs in the third individually controllable array. However, in other embodiments, the thickness of the second encapsulant spots corresponds to, or even exceeds, the thickness of the luminescent encapsulant layer, such that the encapsulant layer does not reach across the second encapsulant spots, and does not cover the LEDs in the third individually controllable array. In this case, when the second encapsulant spots are non-luminescent, at least some light emitted from the blue LEDs in the third array will be emitted without any wavelength conversion.

The first luminescent material may comprise green-yellow phosphor particles and red phosphor particles. The second luminescent material may comprise red phosphor particles, and optionally green-yellow phosphor particles. The third luminescent material - if present - may comprise green-yellow phosphor particles and may be free from red phosphor particles.

It is noted that the first luminescent material is configured to at least partly convert the first, second and/or third blue LED light into first converted light. In a similar way, the second luminescent material is configured to at least partly convert the second blue LED light into second converted light. And finally, the third luminescent material, if present, is configured to at least partly convert the third blue LED light into third converted light.

The first blue LED light may have a first dominant peak wavelength, λ1, the second blue LED light may have a second dominant peak wavelength, λ2, and the third blue LED light may have a third dominant peak wavelength, λ3. The dominant peak wavelengths may be relatively close together, so that |λ2-λ1|≤20 nm and/or |λ3-λ2|≤20 nm. However, preferably, the dominant peak wavelengths are further apart, so that |λ2-λ1|≥20 nm and/or |λ3-λ2|≥20 nm. Such separation of the dominant peak wavelengths may be advantageous. For example, the first and second dominant wavelengths, λ1 and λ2, may be closer to an excitation maximum of the second luminescent material, thereby leading to a higher (luminescent) conversion by the first luminescent spots, while the third dominant wavelength, λ3, may be further away from the excitation maximum. In this way, (relatively) less third blue LED light is converted into first converted light.

In one embodiment, the carrier is light transmissive (e.g. transparent) so that light emitted from the blue LEDs is transmitted through the carrier and emitted out from a back side, opposite to the mounting side. In this case, the LED filament may further comprise third encapsulant spots arranged on the back surface and aligned with the LEDs in the second array, fourth encapsulant spots arranged the back surface and aligned with the LEDs in the third array, and a second luminescent encapsulant layer arranged on the back surface and aligned with the first luminescent encapsulant layer.

The second elongated encapsulant layer may be formed by a fourth luminescent material having a fourth concentration, C4, of luminescent particles, the third encapsulant spots may be formed by a fifth luminescent material having a fifth concentration, C5, of luminescent particles, wherein C5>C4, and the fourth encapsulant spots may be (i) free from a luminescent material, or (ii) formed by a sixth luminescent material having a sixth concentration, C6, of luminescent particles, wherein C6<C4.

It is noted that C1≠C4, and/or C2≠C5, and/or C3≠C6.

A second aspect of the present invention relates to a LED filament lamp, comprising an LED filament according to the first aspect of the invention, and a controller which is configured to individually control the first individually controllable array of blue LEDs, the second individually controllable array of blue LEDs and the third individually controllable array of blue LEDs to vary the correlated color temperature of the emitted LED filament light.

In some embodiments, the lamp further includes an envelope enclosing the LED filament, and a connector for mechanically and electrically connecting the LED filament lamp to a socket of a luminaire.

In some embodiments, the lamp further includes an antenna functionally coupled to the controller of the LED filament lamp, and configured to receive user input from a remote device, wherein the controller is configured to individually control the first individually controllable array of blue LEDs, the second individually controllable array of blue LEDs and the third individually controllable array of blue LEDs based on the user input.

### BRIEF DESCRIPTION OF THE DRAWINGS

The present invention will be described in more detail with reference to the appended drawings, showing currently preferred embodiments of the invention.
Fig. 1a is a perspective view of a LED filament according to prior art
Fig. 1b is a sectional view of the LED filament in figure 1a.
Fig. 2a-g are sectional views of LED filaments according to various embodiments of the present invention.
Fig. 3 is a perspective view of a LED filament lamp according to an embodiment of the invention.

### DETAILED DESCRIPTION OF PREFERRED EMBODIMENTS

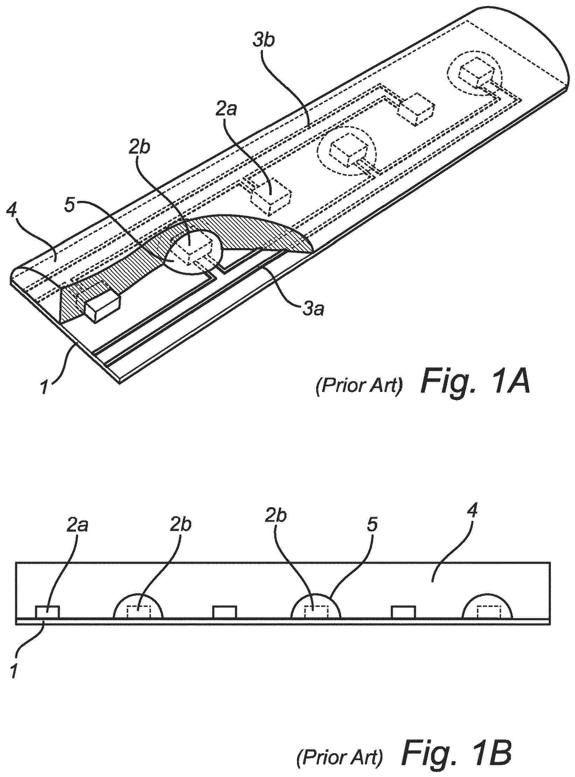

The LED filament in figure 1a-b has an elongated, and generally flat, carrier 1, on which a plurality of blue LEDs 2a, 2b are mounted. The carrier 1 may be made of a rigid material, such as ceramic or metal. It may alternatively be made of a flexible material such as plastic.

The LEDs 2a, 2b are arranged in two LED arrays, individually connected by respective conducting paths 3a, 3b also provided on the carrier 1. All LEDs 2a, 2b are further covered by a luminescent encapsulant layer 4, e.g. formed by a first material comprising phosphor particles. The LEDs 2b in the second array are also covered by luminescent encapsulant spots 5, e.g. formed by a second material comprising phosphor particles. The layer 4 and spots 5 serve to wavelength-convert light emitted from the LEDs 2a, 2b, from blue to white.

The second material (in the spots) has a higher concentration of phosphor particles than the first material (in the layer), such that light emitted from LEDs 2b in the second array will be subject to more wavelength conversion than light emitted by the LEDs 2a in the first array. Light emitted from the LEDs 2a will thus provide a first, higher, color temperature T2 (more blue), while the LEDs 2b in the second array will provide a second, lower color temperature T1 (less blue).
By controlling the two LED arrays separately, the overall color temperature of LED filament light emitted by the LED filament maybe adjusted between two extreme points T1 and T2.

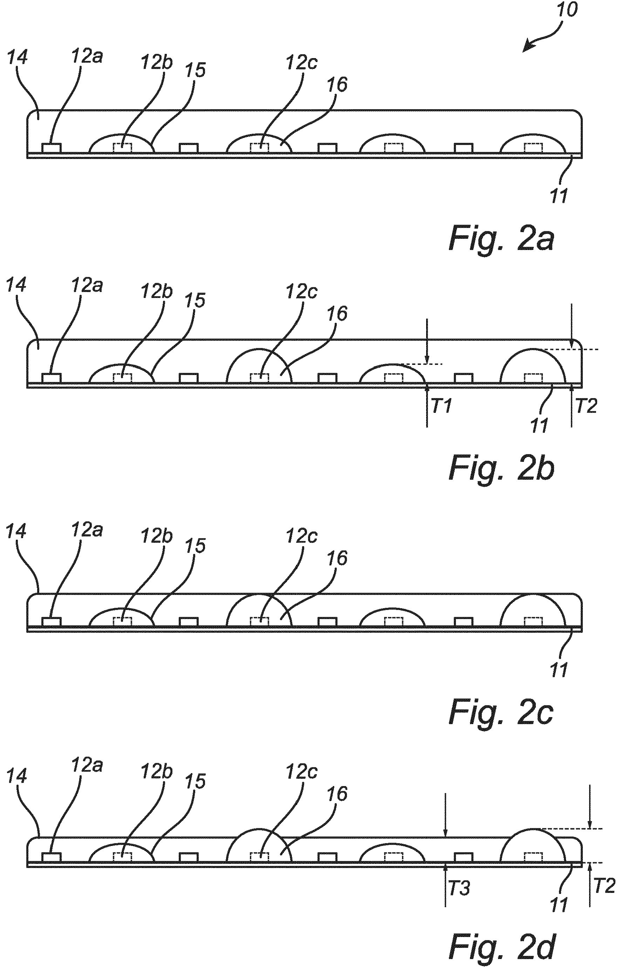

Embodiments of the invention will now be described with reference to figures 2a - 2g.

The LED filament 10 in figure 2a has a carrier 11 and three arrays of blue LEDs 12a, 12b, 12c mounted on a mounting side 11a of the carrier 11. Each LED array is provided with separate electrical connections (not shown) and are individually controllable.

In the illustrated example, all LEDs 12a, 12b, 12c are covered by a luminescent encapsulant layer 14, made of a first luminescent material containing a concentration C1 of luminescent particles, e.g. phosphor particles. Further, the LEDs 12b in the second set are covered by encapsulant spots 15 of a second luminescent material containing a second concentration C2 of luminescent particles, e.g. phosphor particles. The layer 14 and spots 15 may be similar to layer 4 and spots 5 in figure 1a, such that light emitted from the LEDs 12a will have color temperature T2, and light emitted from the LEDs 12b will have color temperature T1.

Further, the LEDs 12c in the third set are covered by encapsulant spots 16 formed of a material which is less luminescent than the layer 14. Light emitted by the LEDs 12c in the third array will therefore be subject to less wavelength conversion than LEDs 12a, 12b in the first and second arrays, and thus have an even higher color temperature T3 (even more blue). As a consequence, the LED filament 10 may be controlled to emit light within a greater color temperature range (T1-T3).

In one embodiment, the spots 16 are formed by a completely non-luminescent material, and could for example be transparent or diffusive. In another embodiment, the spots 16 are formed by a third luminescent material, containing a third concentration C3 of luminescent particles, e.g. phosphor particles.

Only as an illustration, the first luminescent material, in the layer 14, may comprise green-yellow phosphor particles and red phosphor particles. The second luminescent material, in the spots 15, may comprise red phosphor particles, and optionally green-yellow phosphor particles. The third luminescent material - if present in the spots 16-may comprise green-yellow phosphor particles and may be free from red phosphor particles.

As shown in figure 2b, the spots 16 covering the LEDs 12c may have a larger thickness D2 than the thickness D1 of the spots 15. As a consequence, light emitted from the LEDs 12c will pass through less of the luminescent layer 14, and will be subject to even less wavelength conversion. Indeed, as shown in figure 2c, the spots 16 may have a thickness D2 corresponding to the thickness D3 of layer 14. Or even, as shown in figure 2d, exceeding the thickness D3 of the layer 14.

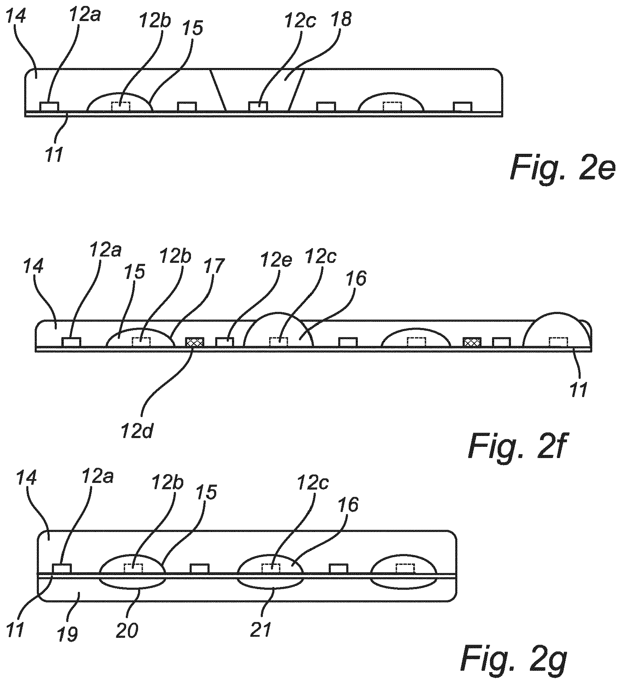

Turning to figure 2e, the LED filament 10e is similar to the filament in figure 2d, except that the encapsulant spots 18 surround the LEDs 12c and are tapered towards the LED 12c. For example, the spot 18 may be conically tapered or pyramidically tapered. Such a shape may ensure an even lower degree of wavelength conversion.

Figure 2f shows a LED filament similar to that in figure 2d, but where additional individually controllable LED arrays emitting different color light have been provided; in the illustrated case an array of red LEDs 12d and an array of green LEDs 12e. Additional controllable LED arrays may further improve the color temperature control of the LED filament. Also, the additional LED arrays will provide significantly enhanced opportunities for color control, which maybe especially beneficial in combination with the improved color temperature control.

Figure 2g shows a LED filament where the carrier 11 is transparent, i.e. light emitted by the LEDs 12a, 12b, 12c will also be transmitted through the carrier to be emitted on the back side 11b, opposite the mounting side 11a. In order to ensure that light emitted on the back side has the same, or at least similar, color temperature as light emitted on the front side, also the back side has been provided with a luminescent layer 19, similar to layer 14. Further, luminescent spots 20 and 21, corresponding to spots 15 and 16, have been provided on the back side, aligned with the LEDs 12b and 12c, respectively. As the amount of light reaching the back side will be smaller than the amount of light emitted from the front side, the thickness of the spots 20, 21, as well as thickness of the layer 19, can be smaller than corresponding thicknesses of spots 15, 16 and layer 14. Alternatively, the thicknesses may be the same, but the concentration C4 of phosphor particles in the layer 19 and/or the concentrations C5, C6 of phosphor particles in the spots 15, 16 may be different compared to the concentrations C1, C2 and C3, respectively.

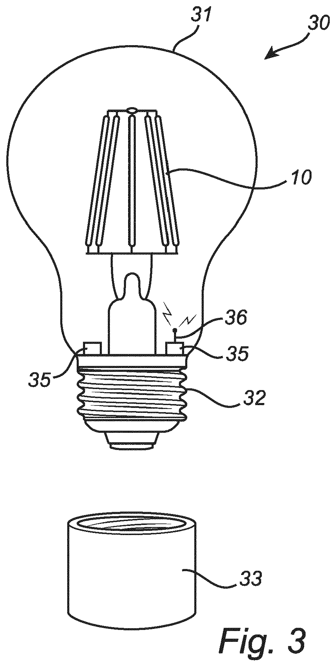

The LED filament lamp 30 in figure 3 generally includes a light transmissive envelope 31 and a connector 32 configured to electrically and mechanically connect the lamp to a socket 33. The connector 32 is here a threaded connector complying with existing light bulb socket standards, e.g. E27. The envelope 32 may be made of glass or plastic, and may be transparent (clear) or diffusive, depending on the desired illumination. Inside the envelope 32 are arranged one or more, in the illustrated case four, LED filaments 10 according to one of the examples in figures 2a-g.

The lamp 30 further includes driver circuitry 34 for driving the individually controllable LED arrays, and a controller 35 for controlling the driver circuitry 35. The controller 35 may receive a control signal remotely, by means of an antenna 36. The control signal may be generated by a user input on a remote device, e.g. a handheld device such as a smartphone, etc.

The person skilled in the art realizes that the present invention by no means is limited to the preferred embodiments described above. On the contrary, many modifications and variations are possible within the scope of the appended claims.

## Claims

1. A LED filament (10) providing LED filament light, comprising:
an elongated carrier (11);
a plurality of blue LEDs (12a, 12b, 12c) mounted on a mounting side (11a) of the elongated carrier, wherein the plurality of blue LEDs (12a, 12b, 12c) includes:
a first individually controllable array of blue LEDs (12a) emitting first blue LED light,
a second individually controllable array of blue LEDs (12b) emitting second blue LED light, and
a third individually controllable array of blue LEDs (12c) emitting third blue LED light; and
an elongated encapsulant layer (14) covering all LEDs (12a) in the first individually controllable array and all LEDs (12b) in the second individually controllable array, said elongated encapsulant layer formed by a first luminescent material having a first concentration, C1, of luminescent particles,
wherein the blue LEDs (12b) in the second individually controllable array are covered by first encapsulant spots (15) formed by a second luminescent material having a second concentration, C2, of luminescent particles, wherein C2>C1, and
wherein the blue LEDs (12c) in the third individually controllable array are covered by second encapsulant spots (16); wherein:
(i) the second encapsulant spots are free from a luminescent material,
or
(ii) the second encapsulant spots are formed by a third luminescent material having a third concentration, C3, of luminescent particles, and wherein C3<C1, and
wherein the second encapsulant spots are at least partly covered by the elongated encapsulant layer (14).

2. The LED filament according to claim 1, wherein C1/C2<0.5 and/or C3/C1<0.5.

3. The LED filament according to any one of the preceding claims, wherein the second encapsulant spots are free from a luminescent material and,
wherein the second encapsulant spots (16) are translucent or comprise a light scattering material.

4. The LED filament according to any one of the preceding claims, wherein a thickness (D2) of the second encapsulant spots (16) is greater than a thickness (D1) of the first encapsulant spots (15).

5. The LED filament according to any one of the preceding claims, wherein the elongated encapsulant layer (14) covers all LEDs (12c) in the third individually controllable array.

6. The LED filament according to any one of the preceding claims 1-4, wherein a thickness (D2) of the second encapsulant spots (16) corresponds or exceeds a thickness (D3) of the luminescent encapsulant layer (14).

7. The LED filament according to any one of the preceding claims, wherein the first luminescent material comprises green-yellow phosphor particles and red phosphor particles, and/or wherein the second luminescent material comprises red phosphor particles, and optionally green-yellow phosphor particles.

8. The LED filament according to any one of the preceding claims, wherein, when the second encapsulant spot is formed by a third luminescent material having a third concentration, C3, of luminescent particles, the third luminescent material comprises green-yellow phosphor particles and is free from red phosphor particles.

9. The LED filament according to any one of the preceding claims, wherein the first blue LED light has a first dominant peak wavelength, λ1, the second blue LED light has a second dominant peak wavelength, λ2, and the third blue LED light has a third dominant peak wavelength, λ3, and wherein |λ2-λ1|≥20 nm and/or |λ3-λ2|≥20 nm.

10. The LED filament according to one of the preceding claims, wherein the elongated carrier (11) is light transmissive so that light from the blue LEDs (12a, 12b, 12c) is emitted also from a back side (11b), opposite to the mounting side (11a), and wherein the LED filament further comprises:
third encapsulant spots (20) arranged on the back surface and aligned with the blue LEDs (12b) of the second individually controllable array,
fourth encapsulant spots (21) arranged the back surface and aligned with the blue LEDs (12c) of the third individually controllable array, and
a second elongated luminescent encapsulant layer (19) arranged on the back side (11b) and aligned with the first luminescent encapsulant layer (14).

11. The LED filament according to claim 10, wherein the second elongated encapsulant layer (19) is formed by a fourth luminescent material having a fourth concentration, C4, of luminescent particles,
wherein the third encapsulant spots (20) are formed by a fifth luminescent material having a fifth concentration, C5, of luminescent particles, wherein C5>C4, and
wherein the fourth encapsulant spots (21) are
(i) free from a luminescent material, or
(ii) formed by a sixth luminescent material having a sixth concentration, C6, of luminescent particles, and wherein C6<C4.

12. The LED filament according to claim 11, wherein C1≠C4, and/or C2≠C5, and/or C3≠C6.

13. A LED filament lamp (30) comprising:
an LED filament according to any one of the preceding claims, and
a controller (35), wherein said controller is configured to individually control said first individually controllable array of blue LEDs (12a), said second individually controllable array of blue LEDs (12b) and said third individually controllable array of blue LEDs (12c) to vary the correlated color temperature of the LED filament light.

14. A LED filament lamp (30) according to claim 13, further comprising:
an envelope (31) at least partly enclosing the LED filament, and
a connector (32) for mechanically and electrically connecting the LED filament lamp to a socket of a luminaire.

15. The LED filament lamp (30) according to claim 13 or 14, further comprising:
an antenna (36) functionally coupled to the controller (35) of the LED filament lamp, and configured to receive user input from a remote device;
wherein the controller (35) is configured to individually control said first individually controllable array of blue LEDs (12a), said second individually controllable array of blue LEDs (12b) and said third individually controllable array of blue LEDs (12c) based on said user input.

## Patentansprüche

1. LED-Filament (10), das LED-Filamentlicht bereitstellt, umfassend:
einen länglichen Träger (11);
eine Vielzahl von blauen LEDs (12a, 12b, 12c), die auf einer Montageseite (11a) des länglichen Trägers montiert sind, wobei die Vielzahl von blauen LEDs (12a, 12b, 12c) einschließt:
eine erste individuell steuerbare Anordnung von blauen LEDs (12a), die erstes blaues LED-Licht emittiert,
eine zweite individuell steuerbare Anordnung von blauen LEDs (12b), die zweites blaues LED-Licht emittiert, und
eine dritte individuell steuerbare Anordnung von blauen LEDs (12c), die drittes blaues LED-Licht emittiert; und
eine längliche Verkapselungsmittelschicht (14), die alle LEDs (12a) in der ersten individuell steuerbaren Anordnung und alle LEDs (12b) in der zweiten individuell steuerbaren Anordnung abdeckt, wobei die längliche Verkapselungsmittelschicht durch einen ersten Leuchtstoff ausgebildet ist, der eine erste Konzentration, C1, von Leuchtpartikeln aufweist,
wobei die blauen LEDs (12b) in der zweiten individuell steuerbaren Anordnung durch erste Verkapselungsmittelpunkten (15) abgedeckt sind, die durch einen zweiten Leuchtstoff ausgebildet sind, der eine zweite Konzentration, C2, von Leuchtpartikeln aufweist, wobei C2>C1, und
wobei die blauen LEDs (12c) in der dritten individuell steuerbaren Anordnung durch zweite Verkapselungsmittelpunkte (16) abgedeckt sind; wobei:
(i) die zweiten Verkapselungsmittelpunkte frei von einem Leuchtstoff sind, oder
(ii) die zweiten Verkapselungsmittelpunkte durch einen dritten Leuchtstoff ausgebildet sind, der eine dritte Konzentration, C3, von Leuchtpartikeln aufweist, und wobei C3<C1, und
wobei die zweiten Verkapselungsmittelpunkte mindestens teilweise durch die längliche Verkapselungsmittelschicht (14) abgedeckt sind.

2. LED-Filament nach Anspruch 1, wobei C1/C2<0,5 und/oder C3/C1<0,5.

3. LED-Filament nach einem der vorstehenden Ansprüche, wobei die zweiten Verkapselungsmittelpunkte frei von einem Leuchtstoff sind und,
wobei die zweiten Verkapselungsmittelpunkte (16) durchscheinend sind oder ein lichtstreuendes Material umfassen.

4. LED-Filament nach einem der vorstehenden Ansprüche, wobei eine Dicke (D2) der zweiten Verkapselungsmittelpunkte (16) größer als eine Dicke (D1) der ersten Verkapselungsmittelpunkte (15) ist.

5. LED-Filament nach einem der vorstehenden Ansprüche, wobei die längliche Verkapselungsmittelschicht (14) alle LEDs (12c) in der dritten individuell steuerbaren Anordnung abdeckt.

6. LED-Filament nach einem der vorstehenden Ansprüche 1 bis 4, wobei eine Dicke (D2) der zweiten Verkapselungsmittelpunkte (16) einer Dicke (D3) der durchscheinenden Verkapselungsmittelschicht (14) entspricht oder diese überschreitet.

7. LED-Filament nach einem der vorstehenden Ansprüche, wobei der erste Leuchtstoff grün-gelbe Phosphorpartikel und rote Phosphorpartikel umfasst, und/oder wobei der zweite Leuchtstoff rote Phosphorpartikel und wahlweise grün-gelbe Phosphorpartikel umfasst.

8. LED-Filament nach einem der vorstehenden Ansprüche, wobei, wenn der zweite Verkapselungsmittelpunkt durch ein drittes durchscheinendes Material ausgebildet wird, das eine dritte Konzentration, C3, von durchscheinenden Partikeln aufweist, der dritte Leuchtstoff grün-gelbe Phosphorpartikel umfasst und frei von roten Phosphorpartikeln ist.

9. LED-Filament nach einem der vorstehenden Ansprüche, wobei das erste blaue LED-Licht eine erste farbtongleiche Spitzenwellenlänge, λ1, aufweist, das zweite blaue LED-Licht eine zweite farbtongleiche Spitzenwellenlänge, λ2, aufweist und das dritte blaue LED-Licht eine dritte farbtongleiche Spitzenwellenlänge, λ3, aufweist, und wobei | λ2-λ1 | ≥20 nm und/oder | λ3-λ2 | ≥20 nm.

10. LED-Filament nach einem der vorstehenden Ansprüche, wobei der längliche Träger (11) lichtdurchlässig ist, sodass Licht von den blauen LEDs (12a, 12b, 12c) ebenso von einer hinteren Seite (11b) gegenüber der Montageseite (11a) emittiert wird, und wobei das LED-Filament ferner umfasst:
dritte Verkapselungsmittelpunkte (20), die auf der hinteren Oberfläche angeordnet und mit den blauen LEDs (12b) der zweiten individuell steuerbaren Anordnung ausgerichtet sind,
vierte Verkapselungsmittelpunkte (21), die auf der hinteren Oberfläche angeordnet und mit den blauen LEDs (12c) der dritten individuell steuerbaren Anordnung ausgerichtet sind, und
eine zweite längliche durchscheinende Verkapselungsmittelschicht (19), die auf der hinteren Seite (11b) angeordnet und mit der ersten durchscheinenden Verkapselungsmittelschicht (14) ausgerichtet ist.

11. LED-Filament nach Anspruch 10, wobei die zweite längliche Verkapselungsmittelschicht (19) durch einen vierten Leuchtstoff ausgebildet ist, der eine vierte Konzentration, C4, von Leuchtpartikeln aufweist,
wobei die dritten Verkapselungsmittelpunkte (20) durch einen fünften Leuchtstoff ausgebildet sind, die eine fünfte Konzentration, C5, von Leuchtpartikeln aufweisen, wobei C5>C4, und
wobei die vierten Verkapselungsmittelpunkte (21) sind
(i) frei von einem Leuchtstoff, oder
(ii) ausgebildet durch einen sechsten Leuchtstoff, der eine sechste Konzentration, C6, von Leuchtpartikeln aufweist, und wobei C6<C4.

12. LED-Filament nach Anspruch 11, wobei C1≠C4 und/oder C2≠C5 und/oder C3≠C6.

13. LED-Filamentlampe (30), umfassend:
ein LED-Filament nach einem der vorstehenden Ansprüche, und
eine Steuerung (35), wobei die Steuerung konfiguriert ist, um die erste individuell steuerbare Anordnung von blauen LEDs (12a), die zweite individuell steuerbare Anordnung von blauen LEDs (12b) und die dritte individuell steuerbare Anordnung von blauen LEDs (12c) individuell zu steuern, um die korrelierte Farbtemperatur des LED-Filamentlichts zu variieren.

14. LED-Filamentlampe (30) nach Anspruch 13, ferner umfassend:
einen Kolben (31), der das LED-Filament mindestens teilweise umschließt, und
einen Verbinder (32) zum mechanischen und elektrischen Verbinden der LED-Filamentlampe mit einer Fassung einer Leuchte.

15. LED-Filamentlampe (30) nach Anspruch 13 oder 14, ferner umfassend:
eine Antenne (36), wirkgekoppelt an die Steuerung (35) der LED-Filamentlampe, und konfiguriert, um eine Benutzereingabe von einer entfernten Vorrichtung zu empfangen;
wobei die Steuerung (35) konfiguriert ist, um die erste individuell steuerbare Anordnung von blauen LEDs (12a), die zweite individuell steuerbare Anordnung von blauen LEDs (12b) und die dritte individuell steuerbare Anordnung von blauen LEDs (12c) basierend auf der Benutzereingabe individuell zu steuern.

## Revendications

1. Filament à DEL (10) produisant une lumière de filament à DEL, comprenant :
un support allongé (11) ;
une pluralité de DEL bleues (12a, 12b, 12c) montées sur un côté de montage (11a) du support allongé, dans lequel la pluralité de DEL bleues (12a, 12b, 12c) comporte :
un premier réseau commandable individuellement de DEL bleues (12a) émettant une première lumière de DEL bleue,
un deuxième réseau commandable individuellement de DEL bleues (12b) émettant une deuxième lumière de DEL bleue, et
un troisième réseau commandable individuellement de DEL bleues (12c) émettant une troisième lumière de DEL bleue ; et
une couche d'encapsulant allongée (14) recouvrant toutes les DEL (12a) dans le premier réseau commandable individuellement et toutes les DEL (12b) dans le deuxième réseau commandable individuellement, ladite couche d'encapsulant allongée étant formée par un premier matériau luminescent ayant une première concentration, C1, de particules luminescentes,
dans lequel les DEL bleues (12b) dans le deuxième réseau commandable individuellement sont recouvertes par de premiers points d'encapsulant (15) formés par un deuxième matériau luminescent ayant une deuxième concentration, C2, de particules luminescentes, dans lequel C2>C1, et
dans lequel les DEL bleues (12c) dans le troisième réseau commandable individuellement sont recouvertes par de deuxièmes points d'encapsulant (16) ;
dans lequel :
(i) les deuxièmes points d'encapsulant sont exempts de matériau luminescent, ou
(ii) les deuxièmes points d'encapsulant sont formés par un troisième matériau luminescent ayant une troisième concentration, C3, de particules luminescentes, et dans lequel C3<C1, et
dans lequel les deuxièmes points d'encapsulant sont au moins partiellement recouverts par la couche d'encapsulant allongée (14).

2. Filament à DEL selon la revendication 1, dans lequel C1/C2 < 0,5 et/ou C3/C1 < 0,5.

3. Filament à DEL selon l'une quelconque des revendications précédentes, dans lequel les deuxièmes points d'encapsulant sont exempts de matériau luminescent et,
dans lequel les deuxièmes points d'encapsulant (16) sont translucides ou comprennent un matériau de diffusion de la lumière.

4. Filament à DEL selon l'une quelconque des revendications précédentes, dans lequel une épaisseur (D2) des deuxièmes points d'encapsulant (16) est supérieure à une épaisseur (D1) des premiers points d'encapsulant (15).

5. Filament à DEL selon l'une quelconque des revendications précédentes, dans lequel la couche d'encapsulant allongée (14) recouvre toutes les DEL (12c) dans le troisième réseau commandable individuellement.

6. Filament à DEL selon l'une quelconque des revendications précédentes 1 à 4, dans lequel une épaisseur (D2) des deuxièmes points d'encapsulant (16) correspond à ou dépasse une épaisseur (D3) de la couche d'encapsulant luminescent (14).

7. Filament à DEL selon l'une quelconque des revendications précédentes, dans lequel le premier matériau luminescent comprend des particules de luminophore vert-jaune et des particules de luminophore rouge, et/ou dans lequel le deuxième matériau luminescent comprend des particules de luminophore rouge, et éventuellement des particules de luminophore vert-jaune.

8. Filament à DEL selon l'une quelconque des revendications précédentes, dans lequel, lorsque le deuxième point d'encapsulant est formé par un troisième matériau luminescent ayant une troisième concentration, C3, de particules luminescentes, le troisième matériau luminescent comprend des particules de luminophore vert-jaune et est exempt de particules de luminophore rouge.

9. Filament à DEL selon l'une quelconque des revendications précédentes, dans lequel la première lumière à DEL bleue a une première longueur d'onde de crête dominante, λ1, la deuxième lumière à DEL bleue a une deuxième longueur d'onde de crête dominante, λ2, et la troisième lumière à DEL bleue a une troisième longueur d'onde de crête dominante, λ3, et dans lequel | λ2-λ1 | ≥20 nm et/ou | λ3-λ2 | ≥20 nm.

10. Filament à DEL selon l'une des revendications précédentes, dans lequel le support allongé (11) transmet la lumière de sorte que la lumière provenant des DEL bleues (12a, 12b, 12c) est également émise à partir d'un côté arrière (11b), opposé au côté de montage (11a), et dans lequel le filament à DEL comprend en outre :
de troisièmes points d'encapsulant (20) agencés sur la surface arrière et alignés avec les DEL bleues (12b) du deuxième réseau commandable individuellement,
de quatrièmes points d'encapsulant (21) agencés sur la surface arrière et alignés avec les DEL bleues (12c) du troisième réseau commandable individuellement, et
une seconde couche d'encapsulant luminescent allongée (19) agencée sur le côté arrière (11b) et alignée avec la première couche d'encapsulant luminescent (14).

11. Filament à DEL selon la revendication 10, dans lequel la seconde couche d'encapsulant allongée (19) est formée par un quatrième matériau luminescent ayant une quatrième concentration, C4, de particules luminescentes,
dans lequel les troisièmes points d'encapsulant (20) sont formés par un cinquième matériau luminescent ayant une cinquième concentration, C5, de particules luminescentes, dans lequel C5>C4, et
dans lequel les quatrièmes points d'encapsulant (21) sont
(i) exempts d'un matériau luminescent, ou
(ii) formés par un sixième matériau luminescent ayant une sixième concentration, C6, de particules luminescentes, et dans lequel C6<C4.

12. Filament à DEL selon la revendication 11, dans lequel C1≠C4, et/ou C2≠C5, et/ou C3≠C6.

13. Lampe à filament à DEL (30) comprenant :
un filament à DEL selon l'une quelconque des revendications précédentes, et
un dispositif de commande (35), dans lequel ledit dispositif de commande est configuré pour commander individuellement ledit premier réseau commandable individuellement de DEL bleues (12a), ledit deuxième réseau commandable individuellement de DEL bleues (12b) et ledit troisième réseau commandable individuellement de DEL bleues (12c) pour faire varier la température de couleur corrélée de la lumière de filament à DEL.

14. Lampe à filament à DEL (30) selon la revendication 13, comprenant en outre :
une enveloppe (31) enfermant au moins partiellement le filament à DEL, et
un connecteur (32) pour connecter mécaniquement et électriquement la lampe à filament à DEL à une douille d'un luminaire.

15. Lampe à filament à DEL (30) selon la revendication 13 ou 14, comprenant en outre :
une antenne (36) couplée fonctionnellement au dispositif de commande (35) de la lampe à filament à DEL, et configurée pour recevoir une entrée utilisateur à partir d'un dispositif distant ;
dans lequel le dispositif de commande (35) est configuré pour commander individuellement ledit premier réseau commandable individuellement de DEL bleues (12a), ledit deuxième réseau commandable individuellement de DEL bleues (12b) et ledit troisième réseau commandable individuellement de DEL bleues (12c) sur la base de ladite entrée utilisateur.
